# EUROPEAN PATENT SPECIFICATION

(11) **EP 3 336 915 B1**
(45) Date of publication and mention of the grant of the patent: **27.11.2024**
(21) Application number: 17204432.3
(22) Date of filing: 29.11.2017
(51) Int. Cl.: H10K 59/35, G02F 1/1335

(54) **DISPLAY DEVICE**
ANZEIGEVORRICHTUNG
AFFICHEUR

(30) Priority: 14.12.2016 KR 20160170725
(43) Date of publication of application: 20.06.2018
(73) Proprietor: LG Display Co., Ltd., Seoul, 07336 (KR)
(72) Inventor: LEE, Se-Min, 10845 Gyeonggi-do (KR); YOON, Hyeok-Joon, 10845 Gyeonggi-do (KR); RHIM, Ju-Sang, 10845 Gyeonggi-do (KR); KIM, Dae-Yong, 10845 Gyeonggi-do (KR); CHOI, Eun-Hee, 10845 Gyeonggi-do (KR); LEE, Se-Jin, 10845 Gyeonggi-do (KR)
(74) Representative: Morrall, Jonathan Ian McLachlan

(56) References cited:
- WO-A1-2015/146708
- US-A1- 2004 108 980
- US-A1- 2006 012 739
- US-A1- 2010 245 738
- US-A1- 2011 043 542
- US-A1- 2015 042 935

## Description

### BACKGROUND

### Field of Technology

The present disclosure relates to a display device, and particularly, relates to a display device which includes a light path adjustment film on a display panel and can maintain a clear image and reduce a lattice-like pattern.

### Discussion of the Related Art

Generally, flat display devices, such as a liquid crystal display device (LCD), a plasma display panel device (PDP), and an organic light emitting diode (OLED) display device, easily achieves high resolution and have various advantages as large-sized display devices.

The display device includes a display panel, which includes a plurality of pixels. The pixel includes sub-pixels displaying respective colors.

In detail, when the display panel is a liquid crystal display panel, it includes an array substrate, an upper substrate and a liquid crystal layer therebetween. The array substrate includes gate lines and data lines crossing each other to define sub-pixel regions, and a thin film transistor as a switching element in each sub-pixel region. The upper substrate includes a color filter and/or black matrix.

When the display panel is an organic light emitting diode display panel, it includes an array substrate and an upper protection substrate. The array substrate includes gate lines and data lines crossing each other to define sub-pixel regions, an organic light emitting diode in each sub-pixel region, and a thin film transistor as a switching element in each sub-pixel region to supply an electric signal to the organic light emitting diode.

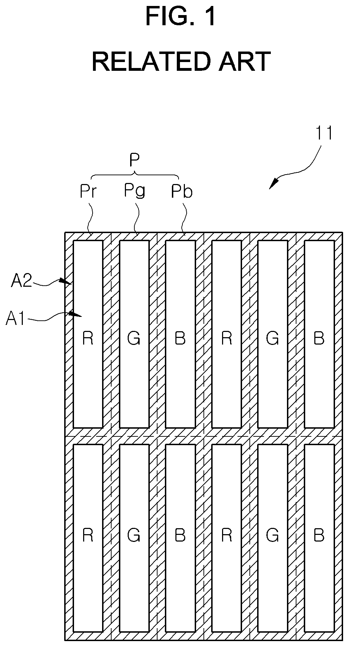

FIG. 1 is a view illustrating an arrangement of sub-pixels of a display panel according to the related art.

Referring to FIG. 1, the display panel 11 includes a plurality of pixels P to display a color image, and each pixel P includes a red sub-pixel Pr, a blue sub-pixel Pb and a green sub-pixel Pg.

Each sub-pixel includes an opening region Al and a non-opening region A2. The opening region Al is a region where a light is output from each sub-pixel, and the non-opening region A2 is a region where a light is not output from each sub-pixel.

The non-opening regions A2 are recognized as a lattice-like pattern by a viewer and becomes a cause of degradation of display quality.

However, there is a limit to reduction of the non-display regions A2 of the sub-pixels Pr, Pg and Pb because of process margin. Various researches have been conducted in order to reduce the lattice-like pattern, but a phenomenon of the image being unclear such as an image blur has happened. Accordingly, a solution to maintain a clear image and reduce a lattice-like pattern is required.

Particularly, when viewing a virtual reality (VR) device, a lattice-like pattern and an image blur are more recognized, and a solution for this is required.

US2011/043542A1 in an abstract states "The present invention provides a display device which can attain higher contrast than that of the conventional display device. The display device (1) comprises: an image light source (2); and an optical sheet (10) having a plurality of layers for controlling an incident light from the image light source and for outputting the light to the observer side, wherein the optical sheet comprises an optical functional sheet layer (12) in which light-transmissive portion(s) (13) configured to transmit light and light-absorbing portion(s) (14) configured to absorb light are alternately arranged along the sheet plane, and only one layer (11) or a plurality of layers of which refractive indices are substantially the same is (are) provided on the observer side of the optical functional sheet layer."

US2006/012739A1 in an abstract states "An object of the invention is to provide an optical collective substrate and a display device using it, which can make effective use of light while avoiding generation of chromatic aberration in transmitted light. An optical substrate ( 20 ) of an optically transmissive material having a structure in which incident light Li from one principal plane ( 21 ) side of the substrate is locally focused toward an array of apertures ( 201 ) formed on the other principal plane ( 22 ). The one principal plane ( 21 ) is provided with grooves 2 v being filled with an optically transmissive substance 2 m of a predetermined refractive index, the filled groove portions 2 V allowing the incident light Li from the one principal plane ( 21 ) side to be collected onto the respective apertures ( 201 )."

WO2015/146708A1 in an abstract states "To provide an anisotropic optical film which exhibits high linear transmittance in a non-diffusion region, and which, as a result of being provided with a broad diffusion region in the MD and TD directions, is capable of solving problems such as glare and the occurrence of abrupt changes in brightness. [Solution] Provided is an anisotropic optical film having, stacked therein, at least two anisotropic light-diffusion layers having linear transmittances which change in accordance with the angle of incident light. Each of the anisotropic light-diffusion layers is provided with a matrix region, and a plurality of columnar regions having refractive indices which are different to that of the matrix region. At least two kinds of anisotropic light-diffusion layers (a, b), in each of which the aspect ratios of the major axes to the minor axes of the columnar regions in a cross section orthogonal to the alignment direction are different to those of the other, are employed as the anisotropic light-diffusion layers. The aspect ratios of the major axes to the minor axes of the columnar regions in the anisotropic light-diffusion layer (a) are less than 2. The aspect ratios of the major axes to the minor axes of the columnar regions in the anisotropic light-diffusion layer (b) are within the range 2-20 inclusive."

US2010/245738A1 in an abstract states "A liquid crystal display device of the present invention includes a liquid crystal display panel, and a light diffusing layer which has first and second major surfaces and which is arranged such that the first major surface opposes a viewer side surface of the liquid crystal display panel. The light diffusing layer includes a first region formed of a first substance which has a first refractive index N1 and a plurality of second regions formed of a second substance which has a second refractive index N2."

US2015/042935A1 in an abstract states "A light control film includes a light shielding layer and a light diffusion portion, and, when an area of a part where the light shielding layer is in contact with one surface of the base material is set to S1, and an area of a part where a low refractive index portion is exposed between light incidence end surfaces is set to S2, the light shielding layer and the light diffusion portion are formed so as to satisfy (S1-S2)/S1×100≧50."

US 2004/108980A1 in an abstract states "The invention provides a display panel having high light-extraction efficiency which can be easily produced. The present invention provides a display panel including an emission layer having a light-emitting layer and a transparent member (transmission layer) having recesses, an inclined surface of the recesses acting as a total reflection surface to reflect part of light radiated from the light-emitting layer. The display panel changes the optical path by total reflection, thus having no light-absorption loss and having high light-extraction efficiency. Since there is no need to deposit a reflecting film, it is easy to produce. Thus, a high-intensity display panel can be provided at low cost."

### SUMMARY

The present invention is set out in the independent claims, with some optional features set out in the claims dependent thereto.

Accordingly, the present disclosure is directed to a display device that substantially obviates one or more of the problems due to limitations and disadvantages of the related art.

An object of the present disclosure is to provide a display device that can maintain a clear image and reduce recognition of a lattice-like pattern.

Additional features and advantages of the invention will be set forth in the description which follows, and in part will be apparent from the description, or may be learned by practice of the invention. These and other advantages of the invention will be realized and attained by the structure particularly pointed out in the written description and claims hereof as well as the appended drawings.

To achieve these and other advantages and in accordance with the purpose of the present disclosure, as embodied and broadly described herein, a display device includes a display panel as described in claims 1 to 4.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a view illustrating an arrangement of sub-pixels of a display panel according to the related art;
FIG. 2 is a schematic cross-sectional view illustrating a display device according to a first embodiment not forming part of the claimed invention;
FIGs. 3 and 4 are views enlarging the pattern of the light path adjustment film according to the first embodiment not forming part of the claimed invention;
FIG. 5 is a schematic view illustrating an arrangement of the sub-pixels of the display panel according to the first embodiment not forming part of the claimed invention;
FIG. 6A is a schematic plan view illustrating the display device according to the first embodiment not forming part of the claimed invention;
FIG. 6B is a schematic cross-sectional view taken along a line VI-VI of FIG. 6A according to the first embodiment of the present disclosure;
FIG. 7A is a schematic plan view illustrating another example of the display device according to the first embodiment not forming part of the claimed invention;
FIG. 7B is a schematic cross-sectional view taken along a line VII-VII of FIG. 7A according to the first embodiment not forming part of the claimed invention;
FIG. 8 is a view illustrating a light path through the light path adjustment film according to the first embodiment not forming part of the claimed invention;
FIG. 9 is a picture of the display device according to the first embodiment not forming part of the claimed invention;
FIG. 10 is a schematic cross-sectional view illustrating a light path adjustment film according to a second embodiment of the present disclosure;
FIG. 11 is a schematic cross-sectional view illustrating a light path adjustment film according to a third embodiment not forming part of the claimed invention;
FIG. 12 is a schematic view illustrating a display device according to a fourth embodiment not forming part of the claimed invention;
FIG. 13 is a schematic plan view illustrating the display device according to the fourth embodiment not forming part of the claimed invention;
FIG. 14 is a cross-sectional view taken along a line XIV-XIV of FIG. 13 according to the fourth embodiment not forming part of the claimed invention;
FIG. 15 is a view illustrating a light path through the light path adjustment film according to the fourth embodiment not forming part of the claimed invention;
FIGs. 16A to 16C are views of another examples of light path adjustment films according to the fourth embodiment not forming part of the claimed invention;
FIG. 17A is a schematic perspective view illustrating a light path adjustment film of a display device according to a fifth embodiment not forming part of the claimed invention;
FIG. 17B is a schematic perspective view illustrating a first pattern portion of a light path adjustment film according to the fifth embodiment not forming part of the claimed invention;
FIG. 17C is a schematic view illustrating a light path of a first pattern layer of a light path adjustment film according to the fifth embodiment not forming part of the claimed invention;
FIG. 17D is a schematic view illustrating a light path of a second pattern layer of a light path adjustment film according to the fifth embodiment not forming part of the claimed invention;
FIG. 18 is a schematic view illustrating light output ranges when passing through the first and second pattern layers in the display device according to the fifth embodiment not forming part of the claimed invention;
FIGs. 19A to 19E are views illustrating another examples of light path adjustment films according to the fifth embodiment not forming part of the claimed invention; FIG. 19F is a schematic view illustrating an example of a light path adjustment film according to an embodiment of the present invention;
FIG. 20 is a picture of the display device according to the fourth or fifth embodiment of the present disclosure;
FIG. 21 is a schematic view illustrating an example of a display device according to an embodiment of the present disclosure; and
FIG. 22 is a schematic view illustrating an example of a display device according to an embodiment of the present disclosure.

### DETAILED DESCRIPTION

Reference will now be made in detail to exemplary embodiments, examples of which are illustrated in the accompanying drawings. The same reference numbers may be used throughout the drawings to refer to the same or like parts.

### <First Embodiment> (not forming part of the claimed invention)

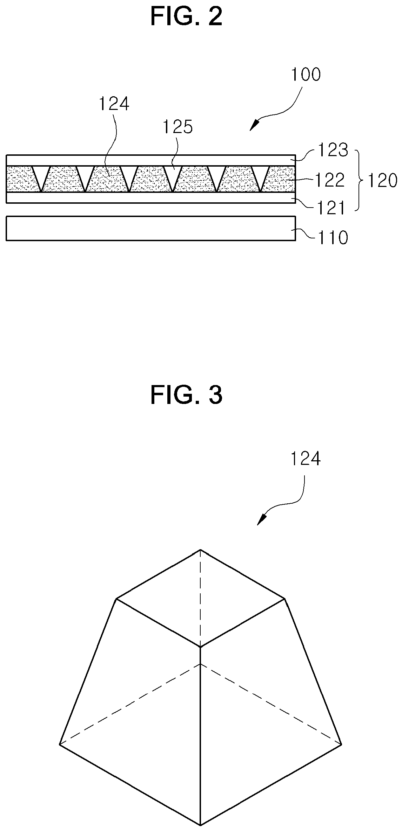

FIG. 2 is a schematic cross-sectional view illustrating a display device according to a first embodiment of the present invention.

Referring to FIG. 2, the display device 100 includes a display panel 110, and a light path adjustment film 120 on the display panel 110.

The light path adjustment film 120 includes a first base film 121, a second base film 123, and a pattern layer 122 between the first and second base films 121 and 123.

The second base film 123 may function to prevent scattering of an external light. Accordingly, when there is no influence of an external light (e.g., when an VR device is used), the second base film 123 may be eliminated from the display device 100.

The first base film 121 supports the pattern layer 122. The first base film 121 may contact the display panel 110 and protect the display panel 110 from a moisture or impact, and thus reliability can be achieved.

The pattern layer 122 may include a plurality of patterns 124 that have a first refractive index, and air gaps 125 that are between the patterns 124 and have a second refractive index less than the first refractive index. The air gap 125 is by way of example in this embodiment, and a material having a refractive index less than the first refractive index may be used.

Each of the first and second base films 121 and 123 may be made of a polyethylene terephthalate (PET), polycarbonate (PC), or acryl based material. The pattern layer 122 may be made of a polycarbonate (PC), or acryl based material.

The light path adjustment film 120 uses the pattern layer 122 to adjust a path of light from the display panel 110 in path and output the light.

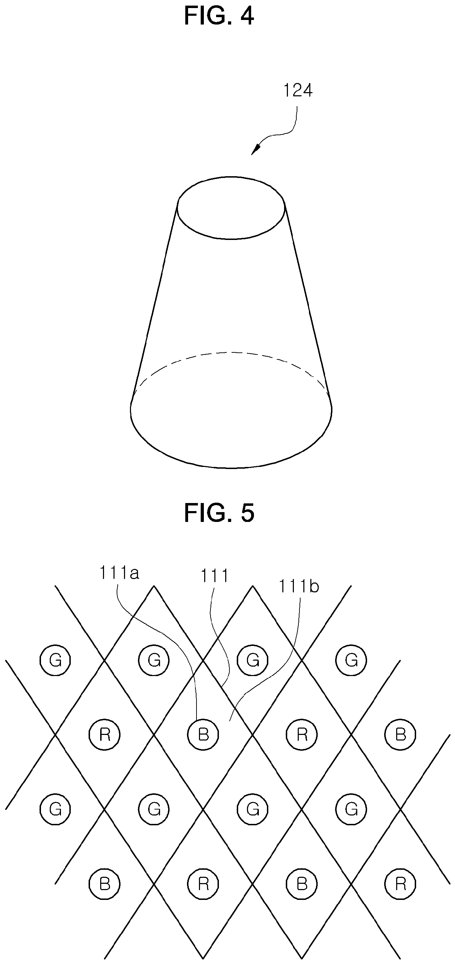

FIGs. 3 and 4 are views enlarging the pattern of the light path adjustment film according to the first embodiment of the present disclosure.

Referring to FIGs. 3 and 4, each pattern 124 of the pattern layer 122 may include a top surface that is spaced apart at a predetermined distance from the display panel 110 and parallel with the display panel 110, a bottom surface that is between the top surface and the display panel 110, and a slanted surface that connects the top surface and the bottom surface at a predetermined slanted angle. The pattern 124 may have, for example, a truncated quadrangular pyramid shape of FIG. 3, or a truncated cone shape of FIG. 4.

The pattern 124 may have other truncated polypyramid shape. In other words, the pattern 124 may be configured such that the top surface and the bottom surface of the pattern 124 are different in size to adjust a path of a light from the display panel 110.

FIG. 5 is a schematic view illustrating an arrangement of the sub-pixels of the display panel according to the first embodiment of the present disclosure.

Referring to FIG. 5, a pentile structure may be used in which a red sub-pixel R and a blue sub-pixel B may be alternately arranged in a same column, and green sub-pixels G may be arranged in a neighboring column. However, other structure and arrangement may be used. Each sub-pixel 111 includes an opening region 111a and a non-opening region 111b.

The opening region 111a is a region where light is output from each sub-pixel 111, and the non-opening region 111b is a region where light is not output from each sub-pixel 111.

The non-opening regions 111b are recognized as a lattice-like pattern by a viewer and becomes a cause of degradation of display quality. However, since the non-opening region 111b are regions where the gate and data lines and the thin film transistors to operate the sub-pixels 111 are formed, there is a limit to reduction of the non-display regions 111b because of process margin.

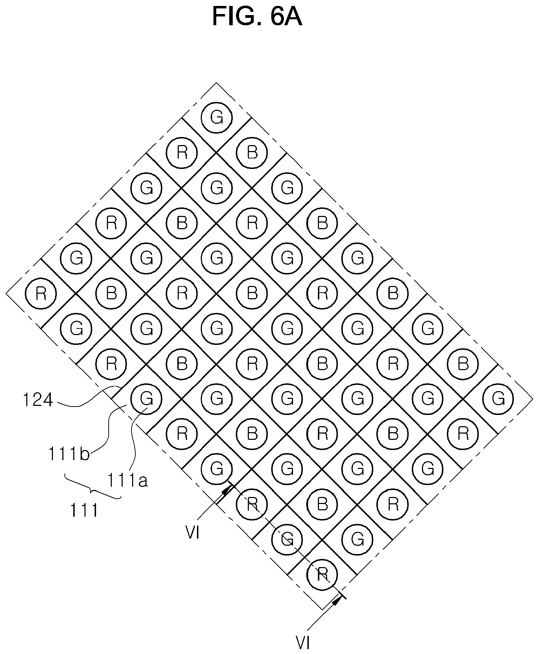

FIG. 6A is a schematic plan view illustrating the display device according to the first embodiment of the present disclosure.

Referring to FIG. 6A, in the sub-pixel arrangement of the pentile structure, the light path adjustment film 120 may be configured such that the patterns 124 of the truncated quadrangular pyramid shape correspond to the respective sub-pixels 111. Each sub-pixel 111 includes the opening region 111a and the non-opening region 111b.

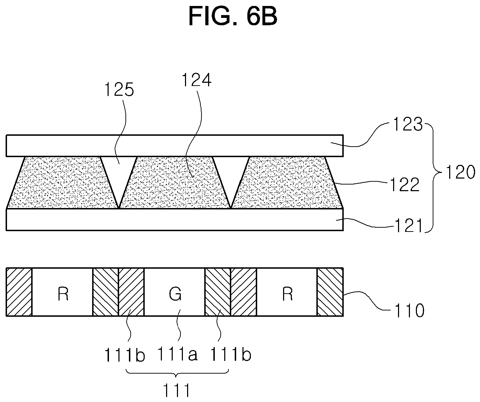

FIG. 6B is a schematic cross-sectional view taken along a line VI-VI of FIG. 6A.

Referring to FIG. 6B, the light path adjustment film 120 is located on the display panel 110.

The light path adjustment film 120 may include the first base film 121, the second base film 123, and the pattern layer 122 between the first and second base films 121 and 123.

The pattern layer 122 may include the plurality of patterns 124 and the plurality of air gaps 125, and each pattern 124 may correspond to each sub-pixel 111. In other words, a pattern is a region of a certain shape.

In detail, each pattern 124 may have a shape such that the pattern 124 includes a top surface that is spaced apart at a predetermined distance from the display panel 110 and parallel with the display panel 110, a bottom surface that is between the top surface and the display panel 110, and a slanted surface that connects the top surface and the bottom surface at a predetermined slanted angle.

In this case, the top surface of the pattern 124 has an area greater than that of the opening region 111a of the sub-pixel 111 to prevent reduction of brightness of the sub-pixel 111. The bottom surface of the pattern 124 has an area greater than that of the top surface to adjust a light path by the slanted surface.

The area of the bottom surface of the pattern 124 is greater than the area of the opening region 111a and is equal to or less than the area of the sub-pixel 111, and the bottom surfaces of the patterns 124 does not overlap each other. Accordingly, each pattern 124 is arranged to correspond to each sub-pixel 111.

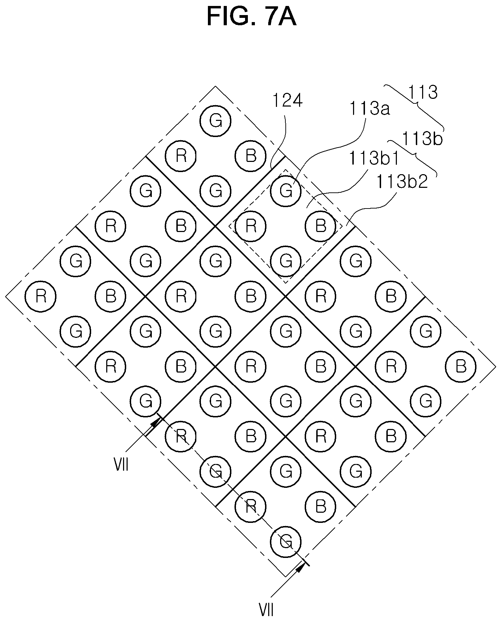

FIG. 7A is a schematic plan view illustrating another example of the display device according to the first embodiment of the present disclosure.

Referring to FIG. 7A, in the arrangement of the pixels 113 of the pentile structure, each pattern 124 of the light path adjustment film 120 may be arranged to correspond to each pixel 113.

Each pixel 113 may include opening regions 113a outputting a light and non-opening regions 113b not outputting a light. Each opening region 113a of the pixel 113 may be formed at each sub-pixel region of the pixel 113.

The non-opening regions 113b may include a second non-opening region 113b2 surrounding a peripheral portion of the opening regions 113a, and a first non-opening region 113b1 between the opening regions 113a.

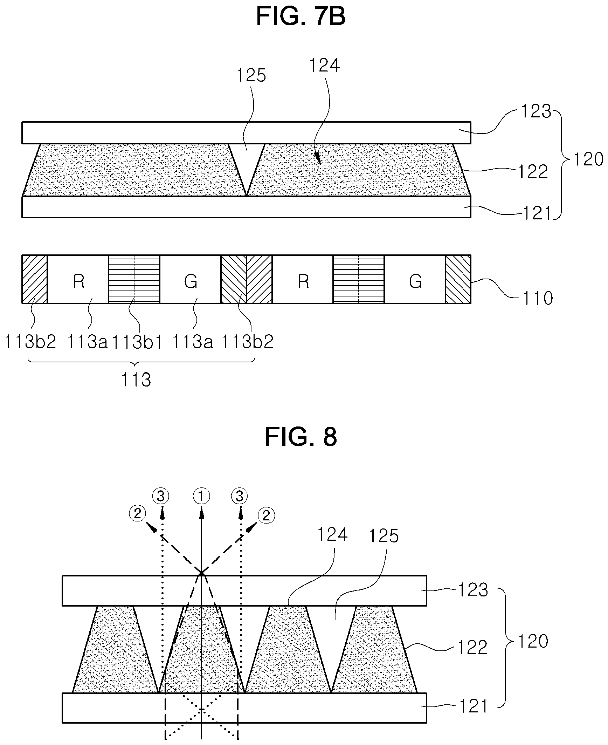

FIG. 7B is a schematic cross-sectional view taken along a line VII-VII of FIG. 7A.

Referring to FIG. 7B, the light path adjustment film 120 is located on the display panel 110.

The light path adjustment film 120 may include the first base film 121, the second base film 123, and the pattern layer 122 between the first and second base films 121 and 123.

The pattern layer 122 may include the plurality of patterns 124 and the plurality of air gaps 125, and each pattern 124 may correspond to each pixel 113.

In detail, each pattern 124 may have a shape such that the pattern 124 includes a top surface that is spaced apart at a predetermined distance from the display panel 110 and parallel with the display panel 110, a bottom surface that is between the top surface and the display panel 110, and a slanted surface that connects the top surface and the bottom surface at a predetermined slanted angle.

In this case, the top surface of the pattern 124 has an area greater than that of the opening regions 113a and the first non-opening region 113b1 of the pixel 113, to prevent reduction of brightness of the pixel 113. The bottom surface of the pattern 124 has an area greater than that of the top surface to adjust a light path by the slanted surface.

The area of the bottom surface of the pattern 124 is greater than the area of the opening regions 113a and the first non-opening region 113b1 of the pixel 113 and is equal to or less than the area of the pixel 113, and the bottom surfaces of the patterns 124 do not overlap each other. Accordingly, each pattern 124 is arranged to correspond to each pixel 113.

FIG. 8 is a view illustrating a light path through the light path adjustment film according to the first embodiment of the present invention.

Referring to FIG. 8, light input through the first base film 121 is adjusted in path while passing through the pattern 124 of the pattern layer 122 then passes through the second base film 123 and then is output.

In detail, light, which is vertically input, from the opening region 111a of each sub-pixel 111, to a center portion of the bottom surface of the pattern 124, passes through the first base film 121, the pattern 124 and the second base film 123 without refraction and then is output as it is (e.g., a light path (1)).

Light, which is input, from the opening region 111a of each sub-pixel 111, to the slanted surface via the bottom surface of the pattern 124, is totally reflected thus adjusted in path and is output to a region that corresponds to the non-opening region 111b of the sub-pixel 111 (e.g., a light path ②).

Light, which is input, from the opening region 111a of each sub-pixel 111, to the slanted surface of the pattern 124, is adjusted in path toward the second base film 123 because of a difference of refractive index between the air gap 125 and the pattern 124, and is output to a region that corresponds to the non-opening region 111b of the sub-pixel 111 (e.g., a light path ③).

Accordingly, when light from each sub-pixel 111 pass through the light path adjustment film 120, the light can be output to a region corresponding to the opening region 111a of the sub-pixel 111 and can also be adjusted in path and output to a region corresponding to the non-opening region 111b of the sub-pixel 111. Thus, a lattice-like pattern can be reduced, and a clear image can be maintained.

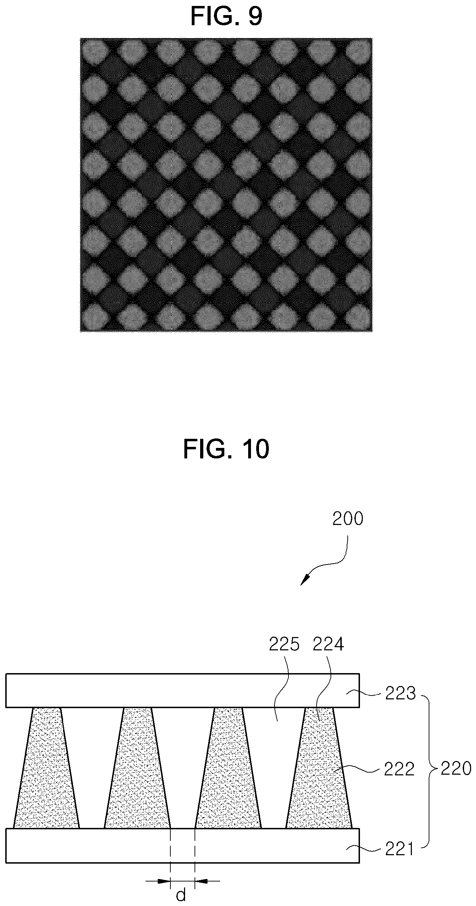

FIG. 9 is a picture of the display device according to the first embodiment of the present invention. Explanations of parts similar to parts of the previous embodiment can be omitted.

Referring to FIG. 9, since the display device 100 of this embodiment outputs lights from each sub-pixel 111 to regions corresponding to the opening region 111a and the non-opening region 111b of the sub-pixel 111 via the light path adjustment film 120, it is seen that a clear image is produced and a lattice-like pattern is reduced.

### <Second Embodiment>

FIG. 10 is a schematic cross-sectional view illustrating a light path adjustment film according to a second embodiment of the present disclosure.

Referring to FIG. 10, the light path adjustment film 220 includes a first base film 221, a second base film 223, and a pattern layer 222 between the first and second base films 221 and 223.

The second base film 223 may function to prevent scattering of an external light. Accordingly, when there is no influence of an external light (e.g., when an VR device is used), the second base film 223 may be eliminated from the display device.

The first base film 221 may contact the display panel (e.g., 110 of FIG. 7B) and protect the display panel from a moisture or impact, and thus reliability can be achieved.

The pattern layer 222 includes a plurality of patterns 224 that have a first refractive index, and air gaps 225 that are between the patterns 224 and have a second refractive index less than the first refractive index. The air gap 225 is by way of example in this embodiment, and a material having a refractive index less than the first refractive index may be used.

Each of the first and second base films 221 and 223 may be made of a polyethylene terephthalate (PET), polycarbonate (PC), or acryl based material. The pattern layer 222 may be made of a polycarbonate (PC), or acryl based material.

Each pattern 224 of the pattern layer 222 is formed such that the pattern 224 includes a top surface that is spaced apart at a predetermined distance from the display panel and parallel with the display panel, a bottom surface that is between the top surface and the display panel, and a slanted surface that connects the top surface and the bottom surface at a predetermined slanted angle.

In this embodiment, the bottom surfaces of the patterns 224 are spaced apart at a predetermined distance d from each other, differently than the first embodiment.

The top surface of the pattern 224 has an area greater than that of the opening region (e.g., 111a of FIG. 6B) of the sub-pixel (e.g, 111 of FIG. 6B) to prevent reduction of brightness of the sub-pixel. The bottom surface of the pattern 224 has an area greater than that of the top surface to adjust a light path by the slanted surface.

The area of the bottom surface of the pattern 224 is greater than the area of the opening region of the sub-pixel, and is less than the area of the sub-pixel in light of the distance d between the bottom surfaces.

### <Third Embodiment> (not forming part of the claimed invention)

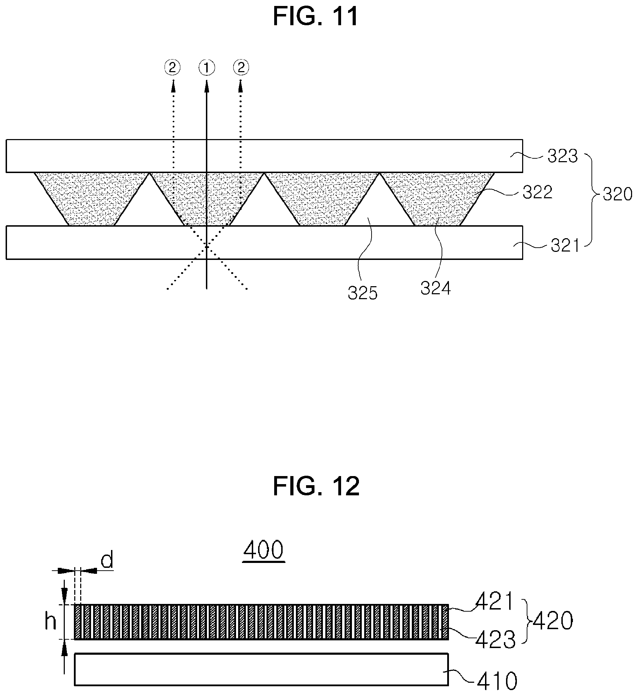

FIG. 11 is a schematic cross-sectional view illustrating a light path adjustment film according to a third embodiment of the present invention. Explanations of parts similar to parts of the previous embodiments can be omitted.

Referring to FIG. 11, each pattern 324 of the pattern layer 322 may has an inverted truncated polypyramid shape, for example, an inverted truncated quadrangular pyramid shape or inverted truncated cone shape, such that the pattern 324 includes a top surface that is spaced apart at a predetermined distance from the display panel (e.g., 110 of FIG. 7B) and parallel with the display panel, a bottom surface that is between the top surface and the display panel, and a slanted surface that connects the top surface and the bottom surface at a predetermined slanted angle.

In this embodiment, the bottom surface of the pattern 324 has an area greater than that of the opening region (e.g., 111a of FIG. 6B) of the sub-pixel (e.g, 111 of FIG. 6B) to prevent reduction of brightness of the sub-pixel. The top surface of the pattern 324 has an area greater than that of the bottom surface to adjust a light path by the slanted surface.

The area of the top surface of the pattern 324 is greater than the area of the opening region of the sub-pixel and is equal to or less than the area of the sub-pixel, and the top surfaces of the patterns 324 do not overlap each other.

In this embodiment, a light input through the first base film 321 is adjusted in path while passing through the pattern 324 of the pattern layer 322 then passes through the second base film 323 and then is output.

In detail, light, which is input, from the opening region (e.g., 111a of FIG. 6B) of each sub-pixel (e.g., 111 of FIG. 6B), to the bottom surface of the pattern 324, passes through the first base film 321, the pattern 324 and the second base film 323 without refraction and then is output as it is (e.g., a light path ①).

Light, which is input, from the opening region of each sub-pixel, to the slanted surface of the pattern 324, is adjusted in path toward the second base film 323 because of a difference of refractive index between the air gap 325 and the pattern 324, and is output to a region that corresponds to the non-opening region (e.g., 111b of FIG. 6B) of the sub-pixel (e.g., a light path ②).

Accordingly, when light from each sub-pixel passes through the light path adjustment film 320, the light can be output to a region corresponding to the opening region of the sub-pixel and can also be adjusted in path and output to a region corresponding to the non-opening region of the sub-pixel. Thus, a lattice-like pattern can be reduced, and a clear image can be maintained.

Further, each pattern 324 may be arranged corresponding to each pixel (e.g., 113 of FIG. 7A).

The light path adjustment structure of this embodiment is a structure that effectively adjusts a light path by gently forming the slanted surface in case of manufacturing the light path adjustment film 320 in a thin film type.

### <Fourth Embodiment> (not forming part of the claimed invention)

FIG. 12 is a schematic view illustrating a display device according to a fourth embodiment of the present disclosure.

Referring to FIG. 12, the display device 400 includes a display panel 410 that includes a plurality of pixels each having sub-pixels, and a light path adjustment film 420 on the display panel 410.

The light path adjustment film 420 may include a plurality of first pattern portions 421 of a cylindrical shape that have a first refractive index, and a plurality of second pattern portions 423 that are between the first pattern portions 421 and have a second refractive index less than the first refractive index.

Alternatively, the light path adjustment film 420 may include a plurality of first pattern portions 421 of a cylindrical shape that have a first refractive index, and a plurality of second pattern portions 423 that are between the first pattern portions 421 and have a second refractive index greater than the first refractive index.

A case that the first refractive index of the first pattern portion 421 is greater than the second refractive index of the second pattern portion 423 is explained below.

The first pattern portion 421 has a cylindrical shape that has a size less than that of the sub-pixel. The cylindrical shape may have a diameter d of, for example, 10µm or less.

The second pattern portion 423 is located between the first pattern portions 421. The second pattern portion 423 may be continuous.

Accordingly, the light path adjustment film 420 includes the plurality of first pattern portions 421 of a cylindrical shape having the first refractive index, and the plurality of second pattern portions 423 that have the second refractive index less than the first refractive index of the first pattern portion 421 and arranged between the first pattern portions 421.

The light path adjustment film 420 may be made of a polycarbonate (PC), or acryl based material.

The first pattern portion 421 may have a height of, for example, 120µm or less.

The display device 400 can adjust a path of light from the display panel 410 using the light path adjustment film 420.

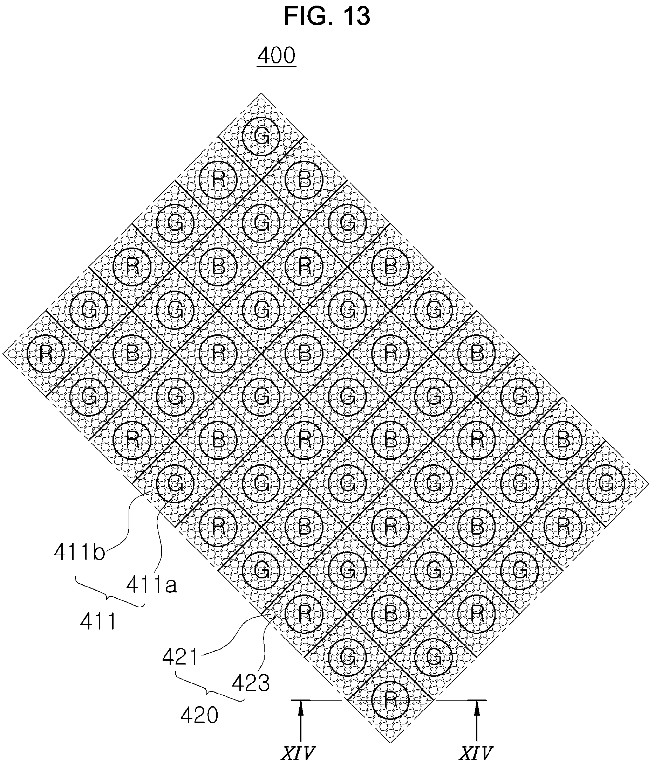

FIG. 13 is a schematic plan view illustrating the display device according to the fourth embodiment of the present disclosure.

Referring to FIG. 13, in the sub-pixel arrangement of the pentile structure, the light path adjustment film 420 is located on the sub-pixels 411.

The plurality of first pattern portions 421 and the plurality of second pattern portions 423 are arranged to correspond to each sub-pixel 411.

Each sub-pixel 411 includes an opening region 411a and a non-opening region 411b.

As described above, the diameter d of the first pattern portion 421 may be less than that of the sub-pixel 411. The first pattern portions 421 may be arranged uniformly or non-uniformly.

Since the light path adjustment film 420 includes the first pattern portion 421 of a minute cylindrical shape, aligning between the opening region 411a of the sub-pixel 411 and the first pattern portion 421 of the light path adjustment film 420 is not needed. Thus, a manufacturing process can be simplified.

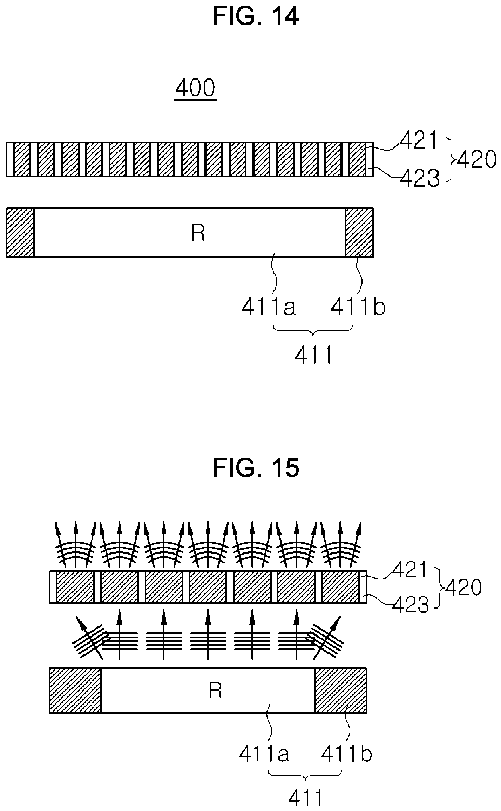

FIG. 14 is a cross-sectional view taken along a line XIV-XIV of FIG. 13.

Referring to FIG. 14, the light path adjustment film 420 is located on the sub-pixel 411.

The light path adjustment film 420 includes the plurality of first pattern portions 421 and the plurality of second pattern portions 423 arranged on the sub-pixel 411.

The first pattern portions 421 have a minute cylindrical shape, and the second pattern portions 423 of the second refractive index less that the first refractive index are arranged between the first pattern portions 421.

The plurality of first pattern portions 421 and the plurality of second pattern portions 423 correspond to each sub-pixel 411.

FIG. 15 is a view illustrating a light path through the light path adjustment film according to the fourth embodiment of the present invention.

Referring to FIG. 15, the non-opening region 411b of the sub-pixel does not output light. Light from the opening region 411a is diffracted while passing through the minute first pattern portions 421 and thus light output range is expanded.

In other words, when the first pattern portion 421 has a minute width that is close to a wavelength of light, light output from the opening region 411a is diffracted while passing through the first pattern portion 421, and a light output range is expanded.

When the width of the first pattern portion is greater than a wavelength of a light, light output from the opening region 411a may be refracted while passing through the first pattern portion 421 and thus light output range may be expanded.

In other words, light input to the first pattern portion 421 is mostly totally reflected and travels in the first pattern portion 421 because of a difference of a refractive index between the first pattern portion 421 and the second pattern portion 423, and while passing through the first pattern portion 421, the light is diffracted or refracted toward a side direction and thus a light output range may be expanded.

Accordingly, when light from each sub-pixel 411 passes through the light path adjustment film 420, the light can be output to a region corresponding to the opening region 411a of the sub-pixel 411 and can also be adjusted in path and output to a region corresponding to the non-opening region 411b of the sub-pixel 411. Thus, a lattice-like pattern can be reduced, and a clear image can be maintained.

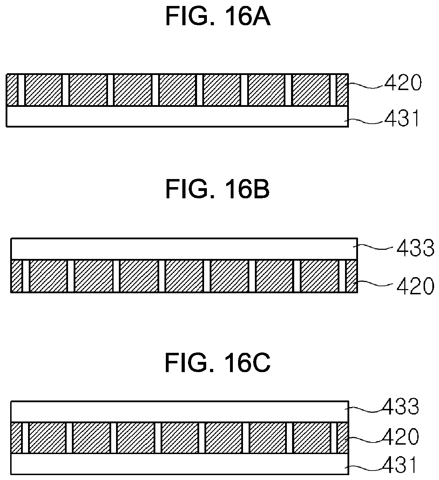

FIGs. 16A to 16C are views of other examples of light path adjustment films according to the fourth embodiment of the present disclosure.

Referring to FIG. 16A, a first base film 431 may be located at a bottom of the light path adjustment film 420.

The first base film 431 supports the light path adjustment film 420. The first base film 431 may contact the display panel 410 and protect the display panel 410 from a moisture or impact, and thus reliability can be achieved.

Referring to FIG. 16B, a second base film 433 may be located at a top of the light path adjustment film 420.

Referring to FIG. 16C, the first base film 431 and the second base film 433 may be located at the bottom and the top of the light path adjustment film 420.

Each of the first and second base films 431 and 433 may be made of a polyethylene terephthalate (PET), polycarbonate (PC), or acryl based material.

As described above, in the display device 400 of this embodiment, the light path adjustment film 420 including the minute-sized first pattern portions 421 and the second pattern portions 423 are employed, and a light output from the opening region 411a of each sub-pixel 411 can be expanded over the non-opening region 411b.

Accordingly, regarding a VR device that eyes of a viewer watch closely, a lattice-like pattern and an image blur can be effectively improved.

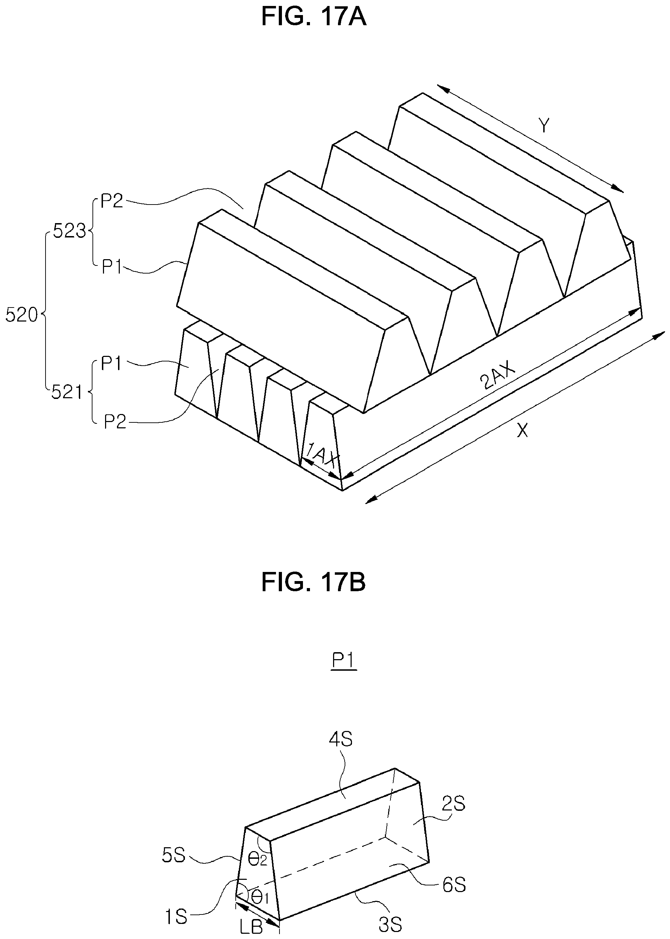

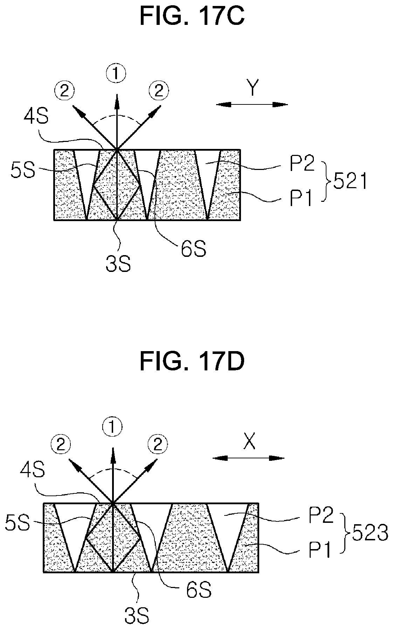

FIG. 17A (not forming part of the claimed invention) is a schematic perspective view illustrating a light path adjustment film of a display device according to a fifth embodiment of the present disclosure, and FIG. 17B (not forming part of the claimed invention) is a schematic perspective view illustrating a first pattern portion of a light path adjustment film according to the fifth embodiment of the present disclosure, FIG. 17C (not forming part of the claimed invention) is a schematic view illustrating a light path of a first pattern layer of a light path adjustment film according to the fifth embodiment of the present disclosure, and FIG. 17D (not forming part of the claimed invention) is a schematic view illustrating a light path of a second pattern layer of a light path adjustment film according to the fifth embodiment of the present disclosure.

Referring to FIG. 17A, the light path adjustment film 520 on the display panel may include a first pattern layer 521, and a second pattern layer 523 on the first pattern layer 521.

Each of the first pattern layer 521 and the second pattern layer 523 may include a plurality of first pattern portions P1 of a bar shape that have a major axis (or long axis) 2AX and a minor axis (or short axis) 1AX, and a plurality of second pattern portions P2 between the first pattern portions P1.

In this case, the major axis 2AX of the first pattern portion P1 of the first pattern layer 521 may be aligned along a first direction X, and the major axis 2AX of the first pattern portion P1 of the second pattern layer 523 may be aligned along a second direction Y perpendicular to the first direction X.

Referring to FIG. 17B, the first pattern portion P1 in each of the first and second pattern layers 521 and 523 may include a first surface 1S of a trapezoidal shape, a second surface 2S of a trapezoidal shape opposite to the first surface 1S, a third surface 3S connecting a bottom side LB of the first surface 1S and a bottom side LB of the second surface 2S, a fourth surface 4S opposite to the third surface 3S, and first and second slanted surfaces 5S and 6S each connecting the third and fourth surfaces 3S and 4S.

Accordingly, the area of the third surface 3S may be greater than the area of the fourth surface 4S.

The first surface 1S and the second surface 2S may be arranged on the minor axis 1AX. The third surface 3S, the fourth surface 4S, the first slanted surface 5S and the second slanted surface 6S may be arranged on the major axis 2AX.

Accordingly, the first pattern portion P1 may have a truncated quadrangular pyramid shape that has an acute angle θ1 and an obtuse angle θ2 and extends along the major axis 2AX.

The acute angle θ1 may be equal to or more than 70 degrees and less than 90 degrees.

A length of the bottom side LB of each of the first and second surfaces 1S and 2S may be 15µm or less.

In each of the first and second pattern layers 521 and 523, the plurality of first pattern portions P1 are arranged, and the plurality of second pattern portions P2 are arranged between the first pattern portions P1 and have a refractive index less than that of the first pattern portions P1.

The first pattern portions P1 may be arranged such that bottom sides of the first and second slanted surfaces 5S and 6S neighboring each other contact each other.

In other words, the first pattern portions P1 may be arranged with the third surfaces thereof contacting each other.

Since the first pattern layer 521 and the second pattern layer 523 are vertically arranged, a light from the display panel (e.g., 410 of FIG. 12) can be expanded along the first direction X and the second direction Y.

Referring to FIG. 17C, a light from the display panel can be expanded along the second direction Y while passing through the first pattern layer 521.

In detail, light, which is vertically input, from the opening region (e.g., 411a of FIG. 15) of each sub-pixel (e.g., 411 of FIG. 15), to a center portion of the third surface 3S of the first pattern layer 521, is output through the fourth surface 4S of the first pattern layer 521 without refraction (e.g., a light path ①).

Light, which is input, from the opening region of each sub-pixel, to the first and second slanted surfaces 5S and 6S via the third surface 3S of the first pattern layer 521, is totally reflected thus adjusted in path and is output to a region, which corresponds to the non-opening region (e.g., 411b of FIG. 15), in the second direction Y, of the sub-pixel, through the fourth surface 4S of the first pattern layer 521 (e.g., a light path ②).

Further, while passing through the minute first pattern portion P1 of the first pattern layer 521, the light is diffracted toward a side direction and thus a light output range may be further expanded along the second direction Y.

Referring to FIG. 17D, the light expanded along the second direction Y can be expanded along the first direction X while passing through the second pattern layer 523.

In detail, light, which is vertically input, from the first pattern layer 521, to a center portion of the third surface 3S of the second pattern layer 523, is output through the fourth surface 4S of the second pattern layer 523 without refraction (e.g., a light path ①).

Light, which is input, from the first pattern layer 521, to the first and second slanted surfaces 5S and 6S via the third surface 3S of the second pattern layer 523, is totally reflected thus adjusted in path and is output to a region, which corresponds to the non-opening region (e.g., 411b of FIG. 15), in the first direction X, of the sub-pixel, through the fourth surface 4S of the second pattern layer 523 (e.g., a light path ②).

Further, while passing through the minute first pattern portion P1 of the second pattern layer 523, the light is diffracted toward a side direction and thus a light output range may be further expanded along the first direction X.

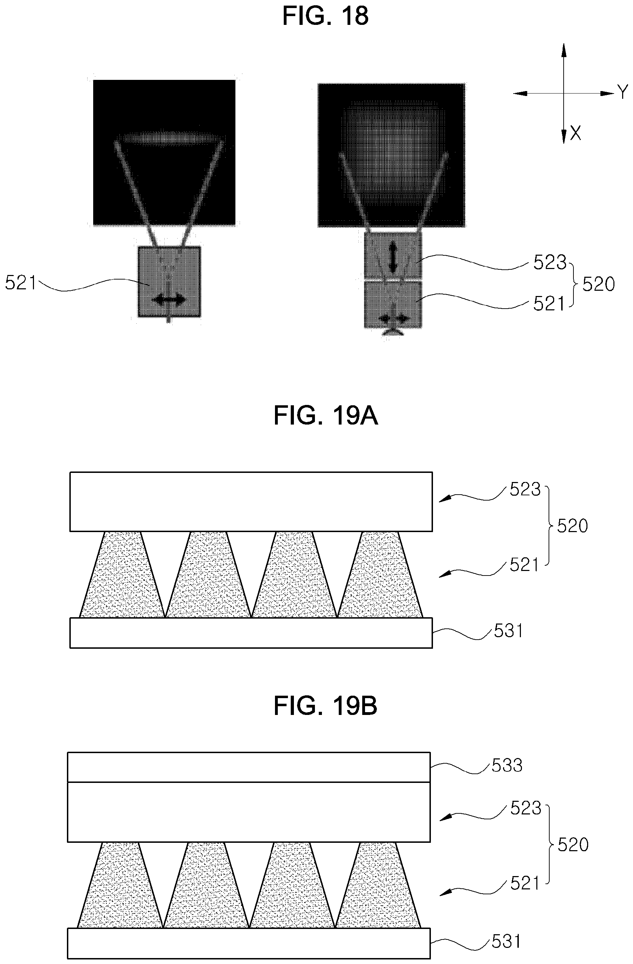

FIG. 18 is a schematic view illustrating light output ranges when passing through the first and second pattern layers in the display device according to the fifth embodiment of the present disclosure.

Referring to FIG. 18, it is seen that light input to the first pattern layer 521 is expanded along the second direction Y while passing through the first pattern layer 521.

Further, it is seen that the light expanded along the second direction Y by the first pattern layer 521 is expanded along the first direction X while passing through the second pattern layer 523.

In other words, a light from the opening region of the sub-pixel can be expanded along the first and second directions X and Y while passing through the light path adjustment film 520 of this embodiment.

Accordingly, a lattice-like pattern produced at the non-opening regions can be effectively improved.

FIGs. 19A to 19F are views illustrating another example of light path adjustment films according to the fifth embodiment of the present disclosure. FIGs. 19A to 19E are not forming part of the claimed invention.

Referring to FIG. 19A, a first base film 531 may be located at a bottom of the light path adjustment film 520.

The first base film 531 supports the light path adjustment film 520. The first base film 531 may contact the display panel and protect the display panel from a moisture or impact, and thus reliability can be achieved.

Referring to FIG. 19B, the first base film 531 and the second base film 533 may be located at the bottom and the top of the light path adjustment film 520, respectively.

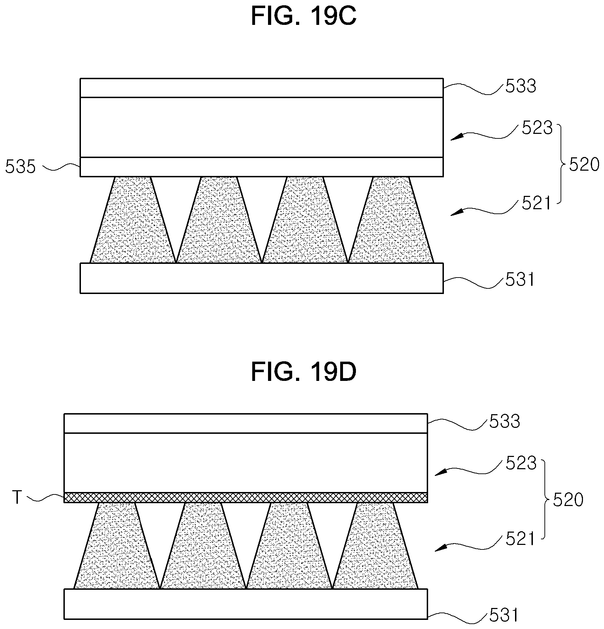

Referring to FIG. 19C, the first base film 531 and the second base film 533 may be attached to the bottom and the top of the light path adjustment film 520, respectively, and a third base film 535 may be located between the first and second pattern layers 521 and 523.

Referring to FIG. 19D, the first base film 531 and the second base film 533 may be attached to the bottom and the top of the light path adjustment film 520, respectively, and an adhesive tape T may be located between the first and second pattern layers 521 and 523.

Each of the first, second and third base films 531, 533 and 535 may be made of a polyethylene terephthalate (PET), polycarbonate (PC), or acryl based material.

The adhesive tape T may be a double-sided adhesive tape coated with an optical adhesive material. Accordingly, the first and second pattern layers 521 and 523 may be firmly fixed.

As described above, the base film 531, 533 or 535 or the adhesive tape T may be arranged in various manners in order to adhere or support the light path adjustment film 520.

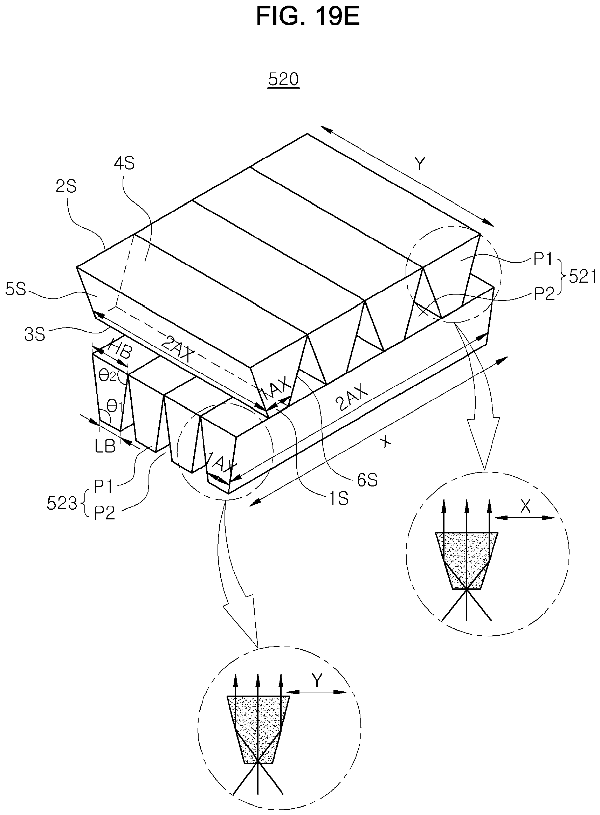

Referring to FIG. 19E, the light path adjustment film 520 may be an inverted arrangement compared with the above examples of this embodiment.

In other words, the second pattern layer 523 may be located on the display panel, and the first pattern layer 521 may be located on the second pattern layer 523.

In this case, each of the first and second pattern layers 521 and 523 may include a plurality of first pattern portions P1 of a bar shape that have a major axis (or long axis) 2AX and a minor axis (or short axis) 1AX, and a plurality of second pattern portions P2 between the first pattern portions P1.

The first pattern portion P1 in each of the first and second pattern layers 521 and 523 may include a first surface 1S of an inverted trapezoidal shape, a second surface 2S of an inverted trapezoidal shape opposite to the first surface 1S, a third surface 3S connecting a bottom side LB of the first surface 1S and a bottom side LB of the second surface 2S, a fourth surface 4S opposite to the third surface 3S, and first and second slanted surfaces 5S and 6S each connecting the third and fourth surfaces 3S and 4S.

Accordingly, the area of the fourth surface 4S may be greater than the area of the third surface 3S.

The first surface 1S and the second surface 2S may be arranged on the minor axis 1AX. The third surface 3S, the fourth surface 4S, the first slanted surface 5S and the second slanted surface 6S may be arranged on the major axis 2AX.

Accordingly, the first pattern portion P1 may have an inverted truncated quadrangular pyramid shape that has an acute angle θ1 and an obtuse angle θ2 and extends along the major axis 2AX.

The acute angle θ1 may be equal to or more than 70 degrees and less than 90 degrees.

A length of a top side HB of each of the first and second surfaces 1S and 2S may be 15µm or less.

In each of the first and second pattern layers 521 and 523, the plurality of first pattern portions P1 are arranged, and the plurality of second pattern portions P2 are arranged between the first pattern portions P1 and have a refractive index less than that of the first pattern portions P1.

Since the first pattern layer 521 and the second pattern layer 523 are vertically arranged, a light from the display panel can be expanded along the first direction X and the second direction Y.

Accordingly, a lattice-like pattern can be effectively improved.

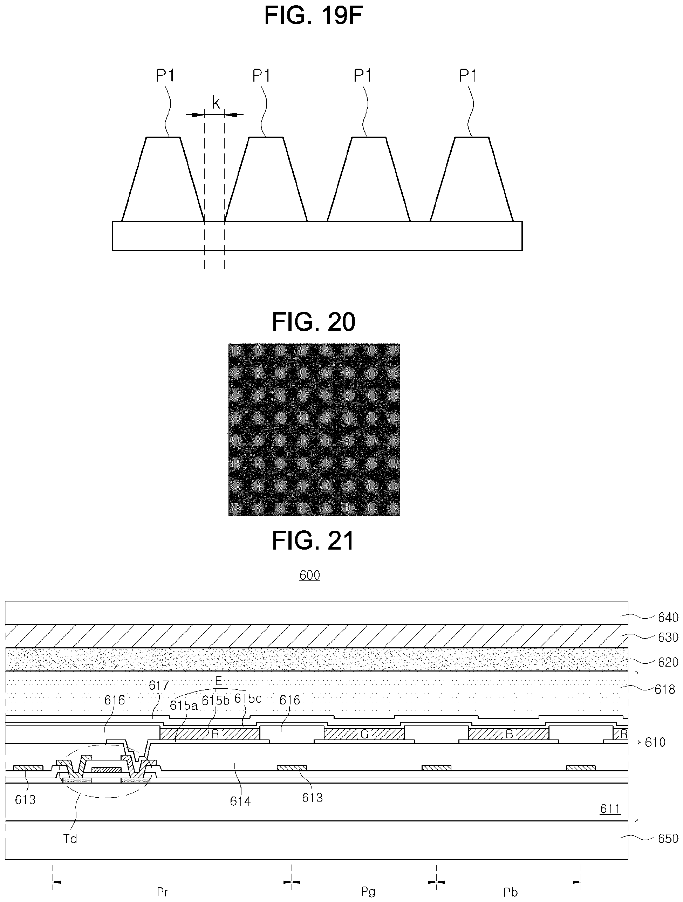

Referring to FIG. 19F, the first pattern portions P1 are spaced apart from each other.

In other words, the first pattern portions P1 of each of the first and second pattern layer 521 and 523 are spaced apart at a predetermined distance k from each other.

The distance k between the first pattern portions P1 may be 10µm or less.

As described above, in this embodiment, the light path adjustment film 520 including the first and second pattern layers 521 and 523 vertically arranged are used. Thus, a light from the opening region of each sub-pixel can be expanded along the first and second directions X and Y, and a lattice-like pattern can be effectively reduced.

FIG. 20 is a picture of the display device according to the fourth or fifth embodiment of the present disclosure.

Referring to FIG. 20, since the display device outputs lights from each sub-pixel (e.g., 411 of FIG. 15) to regions corresponding to the opening region (e.g., 411a of FIG. 15) and the non-opening region (e.g., 411b of FIG. 15) of the sub-pixel via the light path adjustment film (e.g., 420 of FIG. 15 or 520 of FIG. 17), it is seen that a clear image is produced and a lattice-like pattern is reduced.

FIG. 21 is a schematic view illustrating an example of a display device according to an embodiment of the present disclosure. By way of example, an organic light emitting display panel is used for the display device 600.

Referring to FIG. 21, the display device 600 may include a heat sink film 650, an organic light emitting diode (OLED) display panel 610 on the heat sink film 650, a light path adjustment film 620 on the OLED display panel 610, a polarizing plate 630 on the light path adjustment film 620, and a cover glass 640 on the polarizing plate 630 and protecting the OLED display panel 610. One of the light path adjustment films of the above embodiments is used as the light path adjustment film 620.

The heat sink film 650 functions to prevent a heat produced in operating the OLED display panel 610 and a rapid reduction of lifetime due to a deterioration of a driving thin film transistor Td. The heat sink film 650 may be configured to have a continuously uneven shape in order to increase a surface area contacting an ambient air.

The OLED display panel 610 may include a first substrate 611 including a plurality of sub-pixels Pr, Pg and Pb, a plurality of organic light emitting diodes E formed at the respective sub-pixels Pr, Pg and Pb, and an encapsulation layer 618 covering the organic light emitting diodes E.

The driving thin film transistor Td is formed in each sub-pixel on an inner surface of the first substrate 611, and a first passivation layer 614 is formed on the driving thin film transistors Td.

The driving thin film transistor Td includes a semiconductor layer, a gate electrode, a source electrode and a drain electrode. An inter-layered insulating layer is formed on the gate electrode, and a data line 613 is formed on the inter-layered insulating layer.

A first electrode 615a is formed on the first passivation layer 614 in each sub-pixel and is connected to the driving thin film transistor Td. Organic light emitting layers 615b emitting red (R), green (G) and blue (B) are formed in the respective sub-pixels Pr, Pg and Pb. A second electrode 615c is formed entirely on the organic light emitting layers 615b.

A bank layer 616 is formed on the first electrode 615a. The bank layer 616 functions to separate the organic light emitting layers 615b emitting (R), green (G) and blue (B) into the respective sub-pixels Pr, Pg and Pb.

The first electrode 615a, the organic light emitting layer 615b and the second electrode 615c in each sub-pixel constitutes the organic light emitting diode E.

A second passivation layer 617 is formed on the second electrode 615c, and the encapsulation layer 618 is formed on the second passivation layer 617.

The encapsulation layer 618 may be formed with a multi-layered structure using an organic layer and/or an inorganic layer on the second passivation layer 617, or may be formed with a face seal on the second passivation layer 617.

The first substrate 611 may be referred to as a lower substrate, a TFT substrate or backplane and may be made of glass or plastic.

The second passivation layer 617 functions to prevent penetration of a moisture or foreign substance from the outside. The encapsulation layer 618 functions to prevent penetration of a moisture or foreign substance from the outside, and to absorb an external impact as well. The above-described structure of the OLED display panel 610 is by way of example, and the OLED display panel 610 may have other structure.

An adhesive material may be coated on the OLED display panel 610, and the light path adjustment film 620 may be attached to the OLED display panel. Accordingly, a path of a light produced by the OLED display panel 610 is expanded to a region that corresponds to the non-opening region (e.g., 411b of FIG. 15), and thus a clear image can be maintained and a lattice-like pattern can be reduced.

The OLED display panel 610 is protected by the light path adjustment film 620, and reliability of the OLED display panel 610 can further rise.

The polarizing plate 630 prevents light, which is produced by the OLED display panel 610, and an external light, which enters the OLED display panel 610 and is reflected in a reflecting material in the OLED display panel 610, causing a mutual interference and degrading a display performance. In the polarizing plate 630 as a reflection preventing filter, an absorption axis of a polarizer and an optical axis (e.g., an absorption axis) of a retardation film are arranged off-axis to rotate the external light reflected by the reflecting material in the OLED display panel 610.

The light path adjustment film 620 located between the OLED display panel 610 and the polarizing plate 630 is described by way of example. The light path adjustment film 620 may be located at other positions, for example, on the polarizing plate 630.

When the display device 600 is applied to a VR device, the cover glass 640 and the polarizing plate 630 may be eliminated because of a structure of the VR device.

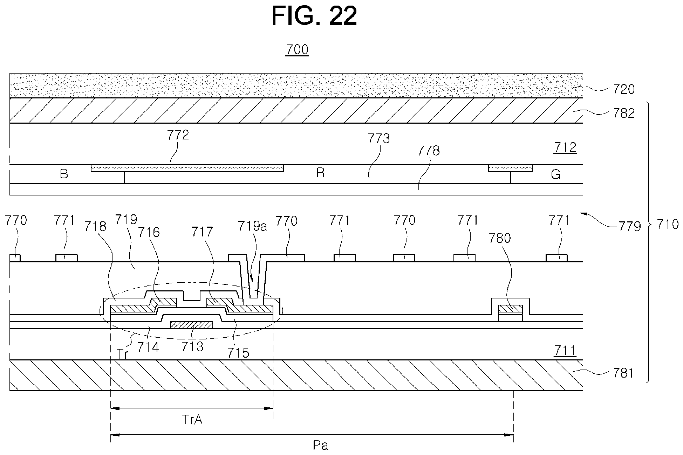

FIG. 22 is a schematic view illustrating an example of a display device according to an embodiment of the present disclosure. By way of example, a liquid crystal display panel is used for the display device.

Referring to FIG. 22, the display device 700 may include a liquid crystal display panel 710 and a light path adjustment film 720 on the liquid crystal display panel 710. One of the light path adjustment films of the above embodiments is used as the light path adjustment film 720.

The liquid crystal display panel 710 may include a first substrate 711, a second substrate 712 and a liquid crystal layer 779 between the first and second substrates 711 and 712.

A plurality of gate lines along a direction are formed on the first substrate 711. A plurality of common lines are formed on the first substrate, and are spaced apart from and parallel with the corresponding gate lines.

A thin film transistor Tr as a switching element is formed in a switching region TrA, and includes a gate electrode 713, a gate insulating layer 714, a semiconductor layer 715, and source and drain electrodes 716 and 717 spaced apart from each other.

A plurality of data lines 780 are formed on the gate insulating layer 714 and cross the plurality of gate lines to define a plurality of sub-pixels Pa. The data line 780 is connected to the source electrode 716.

A first passivation layer 718 made of, for example, an inorganic insulating material is formed on the thin film transistor Tr and the data line 780, and a second passivation layer 719 made of, for example, an organic insulating material are formed on the first passivation layer 718 and has a flat top surface. The first and second passivation layers 718 and 719 have a drain contact hole 719a exposing the drain electrode 717, and a common contact hole exposing the common line.

A plurality of pixel electrodes 770 and a plurality of common electrodes 771 are formed on the second passivation layer 719 in each sub-pixel Pa, and are alternately arranged in the sub-pixel Pa. Each of the pixel electrode 770 and the common electrode 771 is made of a transparent conductive material, for example, ITO or IZO. The pixel electrode 770 is connected to the drain electrode 717 through the drain contact hole 719a, and the common electrode 771 is connected to the common line through the common contact hole.

A black matrix 772 is formed on an inner surface of the second substrate 712, and corresponds to a boundary portion of each sub-pixel and the thin film transistor Tr. A color filter layer 773, which includes red (R), green (G) and blue (B) color filter patterns corresponding to the respective sub-pixels, are formed on the second substrate 712. An edge portion of the color filter pattern may overlap the black matrix 711.

An overcoat layer 778 is formed on the color filter layer 773, and has a flat surface.

First and second polarizing plates 781 and 782 are located on outer surfaces of the first and second substrates 711 and 712. Each of the first and second polarizing plates 781 and 782 transmits light which has a polarized direction parallel with a transmission axis of each of the first and second polarizing plates 781 and 782. Arrangement of the transmission axes of the first and second polarizing plates 781 and 782 and alignment of the liquid crystal molecules determines light transmission. For example, the transmission axes of the first and second polarizing plates 781 and 782 are perpendicular to each other.

The light path adjustment film 720 may be attached on an outer surface of the second polarizing plate 782. Alternatively, the light path adjustment film 720 may be interposed between the second substrate 712 and the second polarizing plate 782. Accordingly, the light path adjustment film 720 expands a path of a light produced by the liquid crystal display panel 710 to a region which corresponds to the non-opening region (e.g., 411b of FIG. 15), and thus the display device 700 which can maintain a clear image and reduce a lattice-like pattern can be achieved.

In this embodiment, the liquid crystal display panel is described by way of example, and other type display panel may be used.

Further, in the above embodiments, the pentile structure is described by way of example, and other structure may be used.

It will be apparent to those skilled in the art that various modifications and variation can be made in the present invention without departing from the scope of the invention. Thus, it is intended that the present invention cover the modifications and variations of this invention provided they come within the scope of the appended claims.

## Claims

1. A display device (100) comprising:
a display panel (110) including a plurality of pixels (113) each having a plurality of sub-pixels (111); and
a light path adjustment film (120) on the display panel,
wherein the light path adjustment film includes a first base film (221, 531), and a pattern layer (222, 521) on a surface of the first base film,
wherein the pattern layer includes a plurality of first patterns (224, (121, P1) having a first refractive index, and a plurality of second patterns (225, P2) between the first patterns and having a second refractive index, wherein the second refractive index is less than the first refractive index,
wherein the second patterns are disposed between the first patterns and the thickness of the second pattern is same as the thickness of the first pattern so that the adjacent first patterns are discretely disposed to each other by the second pattern therebetween, and
wherein the first pattern includes a top surface spaced apart from the display panel and parallel with the display panel, a bottom surface between the top surface and the display panel, and a slanted surface connecting the top surface and the bottom surface:
wherein either:
the bottom surface of the first pattern has a size greater than that of the top surface of the first pattern and wherein each first pattern corresponds to each sub-pixel,
wherein the size of the top surface of the first pattern is greater than that of an opening region (111a, 113a) of the sub-pixel, and
wherein the size of the bottom surface of the first pattern is equal to or less than that of the sub-pixel;
or
the top surface of the first pattern has a size greater than that of the bottom surface of the first pattern; and wherein each first pattern corresponds to each sub-pixel,
wherein the size of the bottom surface of the first pattern is greater than that of an opening region of the sub-pixel, and
wherein the size of the top surface of the first pattern is equal to or less than that of the sub-pixel.

2. The device of claim 1, wherein the light path adjustment film further includes a second base film (223, 531), and the pattern layer is between the first base film and second base film.

3. A display device (100) comprising:
a display panel (110) including a plurality of pixels (113) each having a plurality of sub-pixels (111) ; and
a light path adjustment film (120) on the display panel,
wherein the light path adjustment film includes a first base film (221, 531), and a pattern layer (222, 521) on a surface of the first base film,
wherein the pattern layer includes a plurality of first patterns (224, (124, P1) having a first refractive index, and a plurality of second patterns (225, P2) between the first patterns and having a second refractive index, wherein the second refractive index is less than the first refractive index,
wherein the second patterns are formed disposed between the first patterns and the thickness of the second pattern is same as the thickness of the first pattern so that the adjacent first patterns are discretely disposed to each other by the second pattern therebetween,
wherein the first pattern includes a top surface spaced apart from the display panel and parallel with the display panel, a bottom surface between the top surface and the display panel, and a slanted surface connecting the top surface and the bottom surface;
wherein either:
the bottom surface of the first pattern has a size greater than that of the top surface of the first pattern and
wherein each first pattern corresponds to each pixel,
wherein the size of the top surface of the first pattern is greater than that of opening regions and non-opening regions between the opening regions of the pixel, and
wherein the size of the bottom surface of the first pattern is equal to or less than that of the pixel;
or
the top surface of the first pattern has a size greater than that of the bottom surface of the first pattern; and
wherein each first pattern corresponds to each pixel,
wherein the size of the bottom surface of the first pattern is greater than that of opening regions and non-opening regions between the opening regions of the pixel, and
wherein the size of the top surface of the first pattern is equal to or less than that of the pixel.

4. The device of any preceding claim, wherein the first pattern has a truncated polypyramid shape or truncated cone shape.

## Patentansprüche

1. Anzeigevorrichtung (100), Folgendes umfassend:
eine Anzeigetafel (110), die eine Mehrzahl von Pixeln (113) umfasst, wobei jeder eine Mehrzahl von Subpixeln (111) aufweist; und
einen Lichtweganpassungsfilm (120) auf der Anzeigetafel, wobei der Lichtweganpassungsfilm einen ersten Basisfilm (221, 531) und eine Strukturschicht (222, 521) auf einer Oberfläche des ersten Basisfilms umfasst,
wobei die Strukturschicht eine Mehrzahl erster Strukturen (224, P1) mit einem ersten Brechungsindex und eine Mehrzahl zweiter Strukturen (225, P2) zwischen den ersten Strukturen und mit einem zweiten Brechungsindex umfasst, wobei der zweite Brechungsindex kleiner ist als der erste Brechungsindex,
wobei die zweiten Strukturen zwischen den ersten Strukturen angeordnet sind und die Dicke der zweiten Struktur gleich der Dicke der ersten Struktur ist, so dass die benachbarten ersten Strukturen durch die zweite Struktur dazwischen diskret zueinander angeordnet sind, und
wobei die erste Struktur eine obere Oberfläche, die von der Anzeigetafel beabstandet und parallel zu der Anzeigetafel ist, eine untere Oberfläche zwischen der oberen Oberfläche und der Anzeigetafel und eine geneigte Oberfläche umfasst, welche die obere Oberfläche und die Bodenfläche verbindet;
wobei entweder:
die untere Oberfläche der ersten Struktur eine Größe aufweist, die größer ist als die der oberen Oberfläche der ersten Struktur, und wobei jede erste Struktur jedem Subpixel entspricht,
wobei die Größe der oberen Oberfläche der ersten Struktur größer ist als die eines Öffnungsbereichs (111a, 113a) des Subpixels, und
wobei die Größe der unteren Oberfläche der ersten Struktur gleich oder kleiner ist als die des Subpixels; oder
die obere Oberfläche der ersten Struktur eine Größe aufweist, die größer ist als die der unteren Oberfläche der ersten Struktur, und wobei jede erste Struktur jedem Subpixel entspricht,
wobei die Größe der unteren Oberfläche der ersten Struktur größer ist als die eines Öffnungsbereichs des Subpixels, und
wobei die Größe der oberen Oberfläche der ersten Struktur gleich oder kleiner ist als die des Subpixels.

2. Vorrichtung nach Anspruch 1, wobei der Lichtweganpassungsfilm weiterhin einen zweiten Basisfilm (223, 531) umfasst und die Strukturschicht zwischen dem ersten Basisfilm und dem zweiten Basisfilm ist.

3. Anzeigevorrichtung (100), Folgendes umfassend:
eine Anzeigetafel (110), die eine Mehrzahl von Pixeln (113) umfasst, wobei jeder eine Mehrzahl von Subpixeln (111) aufweist; und
einen Lichtweganpassungsfilm (120) auf der Anzeigetafel, wobei der Lichtweganpassungsfilm einen ersten Basisfilm (221, 531) und eine Strukturschicht (222, 521) auf einer Oberfläche des ersten Basisfilms umfasst,
wobei die Strukturschicht eine Mehrzahl erster Strukturen (224, P1) mit einem ersten Brechungsindex und eine Mehrzahl zweiter Strukturen (225, P2) zwischen den ersten Strukturen und mit einem zweiten Brechungsindex umfasst, wobei der zweite Brechungsindex kleiner ist als der erste Brechungsindex,
wobei die zweiten Strukturen zwischen den ersten Strukturen angeordnet ausgebildet sind und die Dicke der zweiten Struktur gleich der Dicke der ersten Struktur ist, so dass die benachbarten ersten Strukturen durch die zweite Struktur dazwischen diskret zueinander angeordnet sind,
wobei die erste Struktur eine obere Oberfläche, die von der Anzeigetafel beabstandet und parallel zu der Anzeigetafel ist, eine untere Oberfläche zwischen der oberen Oberfläche und der Anzeigetafel und eine geneigte Oberfläche umfasst, welche die obere Oberfläche und die Bodenfläche verbindet;
wobei entweder:
die untere Oberfläche der ersten Struktur eine Größe aufweist, die größer ist als die der oberen Oberfläche der ersten Struktur, und
wobei jede erste Struktur jedem Pixel entspricht,
wobei die Größe der oberen Oberfläche der ersten Struktur größer ist als die der Öffnungsbereiche und der Nicht-Öffnungsbereiche zwischen den Öffnungsbereichen des Pixels, und
wobei die Größe der unteren Oberfläche der ersten Struktur gleich oder kleiner ist als die des Pixels;
oder
die obere Oberfläche der ersten Struktur eine Größe aufweist, die größer ist als die der unteren Oberfläche der ersten Struktur, und
wobei jede erste Struktur jedem Pixel entspricht,
wobei die Größe der unteren Oberfläche der ersten Struktur größer ist als die der Öffnungsbereiche und der Nicht-Öffnungsbereiche zwischen den Öffnungsbereichen des Pixels, und
wobei die Größe der oberen Oberfläche der ersten Struktur gleich oder kleiner ist als die des Pixels.

4. Vorrichtung nach einem vorhergehenden Anspruch, wobei die erste Struktur eine abgeschnittene Polypyramidengestalt oder eine abgeschnittene Kegelgestalt aufweist.

## Revendications

1. Dispositif d'affichage (100) comprenant :
un panneau d'affichage (110) comprenant une pluralité de pixels (113) ayant chacun une pluralité de sous-pixels (111) ; et
un film d'ajustement du trajet de la lumière (120) sur le panneau d'affichage,
dans lequel le film d'ajustement du trajet de la lumière comprend un premier film de base (221, 531) et une couche à motifs (222, 521) sur une surface du premier film de base,
dans lequel la couche à motifs comprend une pluralité de premiers motifs (224, P1) ayant un premier indice de réfraction, et une pluralité de seconds motifs (225, P2) entre les premiers motifs et ayant un second indice de réfraction, où le second indice de réfraction est inférieur au premier indice de réfraction,
dans lequel les seconds motifs sont disposés entre les premiers motifs et l'épaisseur du second motif est identique à l'épaisseur du premier motif, de sorte que les premiers motifs adjacents sont disposés de manière discrète les uns par rapport aux autres par l'intermédiaire du second motif situé entre eux, et
dans lequel le premier motif comprend une surface supérieure séparée du panneau d'affichage et parallèle à celui-ci, une surface inférieure entre la surface supérieure et le panneau d'affichage, et une surface inclinée reliant la surface supérieure et la surface inférieure ;
dans lequel soit :
la surface inférieure du premier motif a une taille supérieure à celle de la surface supérieure du premier motif ; et où chaque premier motif correspond à chaque sous-pixel,
où la taille de la surface supérieure du premier motif est supérieure à celle d'une région d'ouverture (111a, 113a) du sous-pixel, et
où la taille de la surface inférieure du premier motif est égale ou inférieure à celle du sous-pixel ;
soit
la surface supérieure du premier motif a une taille supérieure à celle de la surface inférieure du premier motif ; et où chaque premier motif correspond à chaque sous-pixel,
où la taille de la surface inférieure du premier motif est supérieure à celle d'une région d'ouverture du sous-pixel, et
où la taille de la surface supérieure du premier motif est égale ou inférieure à celle du sous-pixel.

2. Dispositif selon la revendication 1, dans lequel le film d'ajustement du trajet de la lumière comprend en outre un second film de base (223, 531), et la couche à motifs se situe entre le premier film de base et le second film de base.

3. Dispositif d'affichage (100) comprenant :
un panneau d'affichage (110) comprenant une pluralité de pixels (113) ayant chacun une pluralité de sous-pixels (111) ; et
un film d'ajustement du trajet de la lumière (120) sur le panneau d'affichage,
dans lequel le film d'ajustement du trajet de la lumière comprend un premier film de base (221, 531) et une couche à motifs (222, 521) sur une surface du premier film de base,
dans lequel la couche à motifs comprend une pluralité de premiers motifs (224, P1) ayant un premier indice de réfraction, et une pluralité de seconds motifs (225, P2) entre les premiers motifs et ayant un second indice de réfraction, où le second indice de réfraction est inférieur au premier indice de réfraction,
dans lequel les seconds motifs sont formés de manière à être disposés entre les premiers motifs et l'épaisseur du second motif est identique à l'épaisseur du premier motif, de sorte que les premiers motifs adjacents sont disposés de manière discrète les uns par rapport aux autres par l'intermédiaire du second motif situé entre eux,
dans lequel le premier motif comprend une surface supérieure séparée du panneau d'affichage et parallèle à celui-ci, une surface inférieure entre la surface supérieure et le panneau d'affichage, et une surface inclinée reliant la surface supérieure et la surface inférieure ;
dans lequel soit :
la surface inférieure du premier motif a une taille supérieure à celle de la surface supérieure du premier motif, et
où chaque premier motif correspond à chaque pixel,
dans lequel la taille de la surface supérieure du premier motif est supérieure à celle des régions d'ouverture et des régions de non-ouverture entre les régions d'ouverture du pixel, et
dans lequel la taille de la surface inférieure du premier motif est égale ou inférieure à celle du pixel ;
soit
la surface supérieure du premier motif a une taille supérieure à celle de la surface inférieure du premier motif ; et
où chaque premier motif correspond à chaque pixel,
dans lequel la taille de la surface inférieure du premier motif est supérieure à celle des régions d'ouverture et des régions de non-ouverture entre les régions d'ouverture du pixel, et
dans lequel la taille de la surface supérieure du premier motif est égale ou inférieure à celle du pixel.

4. Dispositif selon l'une quelconque des revendications précédentes, dans lequel le premier motif a une forme de polypyramide tronquée ou de cône tronqué.
